# EUROPEAN PATENT SPECIFICATION

(11) **EP 3 998 646 B1**
(45) Date of publication and mention of the grant of the patent: **01.05.2024**
(21) Application number: 21761140.9
(22) Date of filing: 25.02.2021
(51) Int. Cl.: H10N 30/87, H10N 30/06, H01B 1/20, H01B 1/24

(54) **SHEET-SHAPED FLEXIBLE ELECTRODE AND METHOD FOR PRODUCING THE SAME**
BLATTFÖRMIGE FLEXIBLE ELEKTRODE UND VERFAHREN ZU IHRER HERSTELLUNG
ÉLECTRODE FLEXIBLE EN FORME DE FEUILLE ET PROCÉDÉ DE PRODUCTION DE CELLE-CI

(30) Priority: 28.02.2020 JP 2020033346
(43) Date of publication of application: 18.05.2022
(73) Proprietor: Sumitomo Riko Company Limited, Komaki-shi, Aichi 485-8550 (JP)
(72) Inventor: NAKANO, Masayoshi, Komaki-shi, Aichi 485-8550 (JP); NAKASHIMA, Hiroaki, Komaki-shi, Aichi 485-8550 (JP); SHINOZUKA, Tsubasa, Komaki-shi, Aichi 485-8550 (JP); TAKAMATSU, Shigeaki, Komaki-shi, Aichi 485-8550 (JP); MINOSHIMA, Ryo, Komaki-shi, Aichi 485-8550 (JP); FUKUTA, Tomohiro, Komaki-shi, Aichi 485-8550 (JP); KATAYAMA, Kazutaka, Komaki-shi, Aichi 485-8550 (JP); ARIMURA, Shoji, Komaki-shi, Aichi 485-8550 (JP)
(74) Representative: Müller-Boré & Partner Patentanwälte PartG mbB
(86) International application number: PCT/JP2021/007086
(87) International publication number: WO 2021/172425

(56) References cited:
- WO-A1-2016/103559
- JP-A- 2002 292 805
- JP-A- 2009 040 879
- JP-A- 2013 093 171
- JP-A- 2016 153 729
- JP-A- 2016 186 040
- JP-A- 2018 123 266
- JP-A- 2018 123 266

## Description

### Technical Field

The present invention relates to a sheet-shaped electrode that is used in flexible piezoelectric sensors, capacitance sensors and the like.

### Background Art

Amid the rapid expansion of the Internet of Things (IOT), there is an increasing demand for biological information sensors that measure respiratory statuses, heart rates and the like in the fields of nursing care, healthcare and training. In addition, a variety of sensors such as steering sensors and seat sensors are also mounted in vehicles such as automobiles in order to detect the statuses of passengers. For these sensors, in some cases, flexible materials such as elastomers are used from the viewpoint of enhancing followability to the motions of subjects or reducing discomfort. For example, Patent Literature 1 describes an electrode in which a conductive material such as a carbon material is blended with an elastomer as an electrode that configures a sensor. The electrode is produced by applying a conductive paint containing the elastomer and the carbon material onto a substrate.

### [Citation List]

### [Patent Literature]

Patent Literature 1: JP2016153729A
Patent Literature 2: JP2012181084A
Patent Literature 3: WO2015140943A1
Patent Literature 4: JP2017066346A
Patent Literature 5: JP2015183016A
Patent Literature 6: JP2017059627A
Patent Literature 7: JP2013093171 A
Patent Literature 8: JP2002292805 A
Patent Literature 9: JP2018123266 A

### SUMMARY OF INVENTION

### Technical Problem

According to the method for producing an electrode by applying and drying a conductive paint as described in Patent Literature 1, a carbon material is dispersed in a polymer solution containing an elastomer dissolved in an organic solvent to prepare the conductive paint. Therefore, a long time is required for producing the electrode, and it is also difficult to apply the conductive paint thinly with favorable dimension accuracy. In addition, an organic solvent is used at the time of preparing the conductive paint, but there is a demand for suppressing the discharge of volatile organic compounds (VOCs) as an environmental measure. Additionally, there is another need to consider the influence of the organic solvent component on other members adjacent to the electrode.

Due to these points, Patent Literature 2 describes the production of an electrode having a conductive portion containing an elastomer and a carbon material by extrusion molding. Extrusion molding enables continuous production and improves productivity. However, a raw material (a composition containing the elastomer, the carbon material, and the like kneaded therein) needs to have molding processability in order for thin and uniform sheet materials to be continuously produced. For example, electrodes need to be highly conductive in order to increase the detection accuracy of sensors. Therefore, there is a need to blend a relatively large amount of the conductive material with the elastomer; however, in such a case, the molding processability deteriorates due to an increase in the viscosity or the like. Even when extrusion molding is carried out on such a raw material, cracks or tears are caused, and it is not possible to obtain thin and uniform sheet materials. Therefore, it is difficult to continuously produce thin sheet-shaped electrodes by extrusion molding with conventional compositions in which a carbon material is simply blended with an elastomer.

For example, Patent Literature 3 describes the production of an electrode wire by extruding a composition containing a styrene-based thermoplastic elastomer and carbon so as to coat the circumference of a core wire (paragraph [0033]). In Patent Literature 3, extrusion molding is used for the production of a conductor, but the conductor is not molded into a sheet shape. In addition, Patent Literature 4 describes the production of an electrode for a pressure-sensitive switch from a composition containing a styrene-based thermoplastic elastomer, a propylene-based elastomer, carbon black and a process oil. In paragraph [0040] of Patent Literature 4, extrusion molding is exemplified as one of molding methods of the composition, but there are no specific studies for the production of sheet-shaped electrodes. In the examples, there is a description of a sheet for evaluation that is 100 mm in length, 100 mm in width and 1 mm in thickness, but this sheet is produced by the hot pressing of a composition that has been kneaded with an open roll (paragraph [0063] of Patent Literature 4). In addition, Patent Literature 4 contains a description that blending of a highly crystalline resin such as polypropylene is excluded from the viewpoint of flexibility and wear resistance at low temperatures. Furthermore, in Patent Literature 3 and 4, the conductors (compacts) are allowed to contain a large amount of the process oil. In this case, there is a concern that the oil component may bleed out from the conductor and affect other members or detection accuracy. Moreover, Patent Literature 7 shows a positive electrode for lithium secondary battery made of an isoprene styrene block copolymer mixed with carbon black. In Patent Literature 8 a conductive resin sheet where a resin composition contains a styrene resin, a electrically conductive agent such as carbon black, and olefin type thermoplastic elastomer is disclosed and in Patent Literature 9 a conductive resin molded body containing a conductive filler such as carbon black and a conductive resin composition such as a ABS resin is revealed.

The present invention has been made in consideration of such circumstances, and an object of the present invention is to provide a thin sheet-shaped flexible electrode having good conductive properties, and a method for producing the same with excellent productivity. Solution to Problem
(1) In order to solve the above-described problem, a sheet-shaped flexible electrode of the present invention includes a thermoplastic elastomer including a styrene-based thermoplastic elastomer or including a styrene-based thermoplastic elastomer and an olefin-based thermoplastic elastomer, and a conductive material containing carbon black, wherein the melt viscosity of the thermoplastic elastomer at 200°C in a low shear region with a shear rate of 60 s⁻¹ or more and 200 s⁻¹ or less is 100 Pa-s or more and 800 Pa·s or less, and is four times or less the melt viscosity of the thermoplastic elastomer at the same temperature in a high shear region with a shear rate of 1000 s⁻¹ or more and 1220 s⁻¹ or less, an amount of dibutyl phthalate (DBP) absorbed by the carbon black is 300 cm³/100 g or more, and the thickness of the sheet-shaped flexible electrode is 50 µm or more and 500 µm or less.
(2) In order to solve the above-described problem, the method for producing a sheet-shaped flexible electrode of the present invention is for producing the sheet-shaped flexible electrode of the present invention having the configuration of the above-described (1), the method including:
   an elastomer composition production step of producing an elastomer composition including a thermoplastic elastomer and a conductive material, wherein the thermoplastic elastomer includes a styrene-based thermoplastic elastomer or includes a styrene-based thermoplastic elastomer and an olefin-based thermoplastic elastomer, the conductive material contains carbon black, the melt viscosity of the thermoplastic elastomer at 200°C in a low shear region with a shear rate of 60 s⁻¹ or more and 200 s⁻¹ or less is 100 Pa·s or more and 800 Pa·s or less, and is four times or less the melt viscosity of the thermoplastic elastomer at the same temperature in a high shear region with a shear rate of 1000 s⁻¹ or more and 1220 s⁻¹ or less, and the amount of DBP absorbed by the carbon black is 300 cm³/100 g or more; and
   a molding step of molding the elastomer composition into a sheet shape by injecting or extruding.

### Advantageous Effects of Invention

(1) The sheet-shaped flexible electrode of the present invention contains the thermoplastic elastomer as the base material and is thus flexible. The thermoplastic elastomer contains the styrene-based thermoplastic elastomer. The styrene-based thermoplastic elastomer has a high affinity to a carbon material such as carbon black due to a π-π interaction attributed to an aromatic ring. Therefore, the styrene-based thermoplastic elastomer is considered to be highly effective for enhancing conductive properties compared with, for example, olefin-based thermoplastic elastomers. In addition, when the softening point of the elastomer component is low, there is a problem in that different parts in contact with each other of the sheet are likely to stick to each other or the like. Regarding this point, the styrene-based thermoplastic elastomer has a higher softening point than olefin-based thermoplastic elastomers and is thus excellent in terms of handleability and molding processability. The thermoplastic elastomer may contain, in addition to the styrene-based thermoplastic elastomer, an olefin-based thermoplastic elastomer. In a case where the thermoplastic elastomer contains an olefin-based thermoplastic elastomer, physical properties are less likely to deteriorate even when the content of carbon black is relatively large. Therefore, the joint use of the olefin-based thermoplastic elastomer is capable of improving the conductive properties and processability of the sheet-shaped flexible electrode by increasing the content of carbon black.

The thermoplastic elastomer that configures the sheet-shaped flexible electrode of the present invention satisfies the following two requirements (a) and (b).
(a) The melt viscosity at 200°C in a low shear region with a shear rate of 60 s⁻¹ or more and 200 s⁻¹ or less is 100 Pa·s or more and 800 Pa-s or less.
(b) The melt viscosity at 200°C in the low shear region with a shear rate of 60 s⁻¹ or more and 200 s⁻¹ or less is four times or less the melt viscosity at the same temperature in a high shear region with a shear rate of 1000 s⁻¹ or more and 1220 s⁻¹ or less.

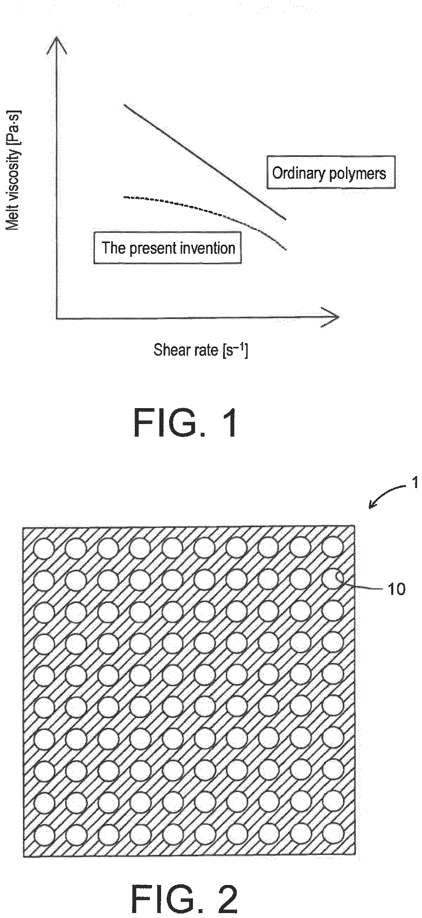

First, the relationship between the melt viscosity and shear rate of polymers will be described. Fig. 1 schematically shows the relationship between the melt viscosity and shear rate of polymers. As shown by the solid line in Fig. 1, normally, the melt viscosity of polymers increases as the shear rate decreases. In contrast, in the case of the thermoplastic elastomer that is used in the sheet-shaped flexible electrode of the present invention, as shown by the broken line in Fig. 1, the melt viscosity is low and less likely to change even when the shear rate decreases. The above-described requirement (a) indicates that the melt viscosity is low in the low shear region, and the requirement (b) indicates that the melt viscosity is low and less likely to change even when the shear rate is slow.

The low shear region with a shear rate of 60 s⁻¹ or more and 200 s⁻¹ or less corresponds to the shear rate at the time of extrusion molding. That is, the melt viscosity of the thermoplastic elastomer that is used in the sheet-shaped flexible electrode of the present invention is low under conditions where extrusion molding is carried out. The use of such a thermoplastic elastomer decreases the viscosity of an elastomer composition for forming the electrode and makes it possible to produce sheet-shaped electrodes with favorable qualities by not only extrusion molding but also injection molding or the like. In addition, the melt viscosity of the thermoplastic elastomer is less likely to change (stable) in the low shear region. Therefore, according to the thermoplastic elastomer, the variation in the viscosity of the elastomer composition depending on conditions such as the molding rate becomes small, and the molding processability improves. In addition, while the elastomer composition is produced by the kneading or the like of a predetermined material, since the condition dependency is small even during this kneading, and thus the robustness becomes favorable.

The melt flow rate (MFR) is an index that indicates the fluidity of polymers, but a difference in flowability with respect to shear rates cannot be indicated with this index. Therefore, in the present invention, the difference in flowability with respect to shear rates is regulated with the melt viscosity.

The sheet-shaped flexible electrode of the present invention has carbon black by which the amount of dibutyl phthalate (DBP) absorbed is 300 cm³/100 g or more as a conductive material. The amount of DBP absorbed is an index that indicates the degree of development of structures, and, as the amount of DBP absorbed increases, structures further develop. In a case where the amount of DBP absorbed by the carbon black is 300 cm³/100 g or more, since the structure has already developed, conductive properties are likely to be exhibited. In addition, while the structure changes during kneading or extrusion molding, when the carbon black is combined with the thermoplastic elastomer that satisfies the aforementioned two requirements (a) and (b), condition dependency also becomes small in terms of conductive properties, and the robustness becomes favorable. As described above, with the sheet-shaped flexible electrode of the present invention, it is possible to satisfy flexibility, conductive properties and molding processability.

The thickness of the sheet-shaped flexible electrode of the present invention is 50 µm or more and 500 µm or less. Since the thickness is relatively thin, the flexibility is excellent, and subjects are less likely to feel discomfort even when touching the sheet-shaped flexible electrode. In addition, as described above, since the elastomer composition for forming the electrode has excellent molding processability, it is possible to continuously produce uniform sheet-shaped electrodes at a thickness of 500 µm or less. As described above, the sheet-shaped flexible electrode of the present invention is also suitable for continuous production.

That is, Patent Literature 5 describes a conductive sheet containing a styrene-based block copolymer and a carbon nanomaterial that is intended to improve conductive properties and antistatic properties. In Paragraph [0031] of Patent Literature 5, a melt extrusion method is exemplified as one of molding methods, but there are no specific studies for the production of sheet-shaped electrodes. In the examples, a conductive sheet is produced by the hot pressing of a composition in which configuration materials of the conductive sheet have been kneaded (Paragraph [0047] of Patent Literature 5). In addition, Patent Literature 6 describes an electromagnetic wave-suppressing sheet containing a styrene-based thermoplastic elastomer and carbon black. However, in Patent Literature 6, only a method in which a solution of a resin composition (conductive paint) is applied and dried is described as a method for producing the electromagnetic wave-suppressing sheet, and the production of the sheet by extrusion molding or the like is not assumed.

(2) According to the method for producing a sheet-shaped flexible electrode of the present invention, first, an elastomer composition having a predetermined thermoplastic elastomer and a conductive material containing carbon black is produced in the elastomer composition production step. As described above, the elastomer composition is excellent in terms of molding processability. Therefore, in the next molding step, thin sheet-shaped flexible electrodes having high conductive properties can be easily produced by the extrusion molding or injection molding of the elastomer composition. In addition, since no conductive paint is used, the production rate can be increased, and no organic solvent is used. In addition, since extrusion molding or injection molding is employed, continuous production becomes possible, and productivity can be enhanced.

### BRIEF DESCRIPTION OF DRAWINGS

Fig. 1 is an explanatory view showing the relationship between the melt viscosity and shear rate of polymers.
Fig. 2 is a schematic plan view of an aspect of a sheet-shaped flexible electrode of the present invention.

### DESCRIPTION OF EMBODIMENTS

Hereinafter, a sheet-shaped flexible electrode of the present invention and a method for producing the same will be described in detail.

### <Sheet-shaped flexible electrode>

The sheet-shaped flexible electrode of the present invention includes: a thermoplastic elastomer including a styrene-based thermoplastic elastomer or including a styrene-based thermoplastic elastomer and an olefin-based thermoplastic elastomer, and a conductive material containing carbon black.

### [Thermoplastic elastomer]

The thermoplastic elastomer contains a styrene-based thermoplastic elastomer. The styrene-based thermoplastic elastomer is a block copolymer or random copolymer having a polymer block composed of polystyrene (hard segment) and a polymer block composed of polyolefin (soft segment). Examples thereof include a styrene-butadiene-styrene block copolymer (SBS), a styrene-ethylene-butylene-styrene block copolymer (SEBS), a styrene-ethylene-propylene-styrene block copolymer (SEPS), a styrene-ethylene-ethylene-propylene-styrene block copolymer (SEEPS) and the like. As the styrene-based thermoplastic elastomer, one species may be singly used or two or more species may be jointly used.

In the styrene-based thermoplastic elastomer, due to the above-described π-π interaction attributed to an aromatic ring, the conductive properties further improve as the styrene content increases. However, when the styrene content increases, the styrene-based thermoplastic elastomer becomes hard, and molding processability deteriorates. Additionally, in a case where the electrode is molded into a sheet shape, then, wound and stored in a roll shape, different parts in contact with each other of the sheet are likely to stick to each other. Therefore, when conductive properties, molding processability, handleability and the like are taken into account, the styrene content is desirably 35 mass% or less. In a case where molding processability is more emphasized, the styrene content is desirably less than 30 mass% and, furthermore, less than 25 mass%. The styrene content refers to the mass proportion of a structural unit derived from styrene in the entire copolymer.

The thermoplastic elastomer may be only the styrene-based thermoplastic elastomer or may be both the styrene-based thermoplastic elastomer and an olefin-based thermoplastic elastomer. As the olefin-based thermoplastic elastomer as well, one olefin-based thermoplastic elastomer may be singly used or two or more olefin-based thermoplastic elastomers may be jointly used. In a case where the thermoplastic elastomer contains the olefin-based thermoplastic elastomer, physical properties are less likely to deteriorate even when the content of carbon black is relatively large. Therefore, when both the styrene-based thermoplastic elastomer and the olefin-based thermoplastic elastomer are used, it is possible to improve the conductive properties and processability of sheet-shaped flexible electrodes by increasing the content of the carbon black. The content of the olefin-based thermoplastic elastomer is desirably set to 50 parts by mass or less in a case where all of the thermoplastic elastomers are set to 100 parts by mass. The content of the olefin-based thermoplastic elastomer is more preferably set to 25 parts by mass or less or 10 parts by mass or less. In the sheet-shaped flexible electrode of the present invention, the main elastomer component is the above-described thermoplastic elastomers, but the sheet-shaped flexible electrode of the present invention may have a different elastomer in addition to the thermoplastic elastomers as long as desired properties are not impaired.

The thermoplastic elastomers satisfy the above-described two requirements (a) and (b) regarding the melt viscosity. From the viewpoint of further improving molding processability, regarding the requirement (a), the melt viscosity at 200°C in the low shear region is desirably 500 Pa·s or less, and, regarding the requirement (b), the ratio between the melt viscosity (melt viscosity in low shear region/melt viscosity in high shear region) is desirably 3.5 times or less and, furthermore, 3.2 times or less. In addition, from the viewpoint of making the sheet-shaped flexible electrode of the present invention flexible, the type-A durometer hardness of the thermoplastic elastomer is preferably less than 60.

### [Conductive material]

The sheet-shaped flexible electrode of the present invention has carbon black by which the amount of DBP absorbed is 300 cm³/100 g or more as the conductive material. In a case where the amount of DBP absorbed is less than 300 cm³/100 g, since the structure does not sufficiently develop, it is difficult to realize desired conductive properties with an amount of the carbon black blended at which the flexibility can be maintained. The sheet-shaped flexible electrode of the present invention may have, in addition to the carbon black, a different material that imparts conductive properties as long as desired flexibility and conductive properties can be realized. Examples thereof include carbon materials such as graphite, carbon nanotubes and carbon nanofibers or metal materials such as silver, gold, copper, platinum and nickel. Among these, graphite is relatively inexpensive and highly conductive and is thus preferable. As the graphite, ordinary powdered graphite, expanded graphite, flake graphite, graphene and the like are exemplary examples.

In the sheet-shaped flexible electrode of the present invention, from the viewpoint of satisfying both flexibility and conductive properties, the content of the conductive material is preferably 10 parts by mass or more and 100 parts by mass or less with respect to 100 parts by mass of the thermoplastic elastomer. When the content of the conductive material is set to 50 parts by mass or less and, furthermore, 30 parts by mass or less, it is possible to further enhance flexibility.

### [Other Components]

The sheet-shaped flexible electrode of the present invention may contain, in addition to the elastomer component such as the thermoplastic elastomers and the conductive material, a resin, a lubricant, a plasticizer, a reinforcing material, an anti-aging agent, a colorant or the like. However, there is a concern that, when configuring sensors or the like, an oil component such as a process oil may bleed out and affect other adjacent members or the detection accuracy of the sensors. Therefore, the sheet-shaped flexible electrode of the present invention desirably contains no oil components. In a case where the sheet-shaped flexible electrode contains an oil component, the content thereof is desirably 10 parts by mass or less in a case where all of the elastomer components are set to 100 parts by mass.

When a lubricant is blended, since it is possible to weaken a shearing force even when a load is applied to the electrode due to press molding or the like, the structure of the carbon black is less likely to collapse. Therefore, it is possible to decrease a load-induced change in conductive properties. As the lubricant, one or more selected from fatty acids and fatty acid compounds are desirably used. Among them, bis-stearamide is preferable from the viewpoint of the electric resistance stabilization and processability stabilization of the sheet-shaped flexible electrode.

In a case where the sheet-shaped flexible electrode of the present invention contains a resin, elastomer portions and resin portions form a sea-island structure. Since the resin portions on the island side play a cushion role, different parts in contact with each other of the electrode are less likely to stick to each other, and handleability improves. In addition, the thickness is less likely to change even when a load is applied. In addition, the carbon black is unevenly distributed in the elastomer portions on the sea side. Therefore, even when a load is applied to the electrode, the form of the carbon black is less likely to change, and the structure is also less likely to collapse. As a result, it is possible to decrease a load-induced change in conductive properties.

The resin to be contained is desirably a relatively hard resin. For example, a resin having a type-A durometer hardness of 80 or more is desirable. Examples of a preferable resin include polyethylene, polypropylene, polyamide, polyethylene terephthalate, polycarbonate and the like. One of these may be used singly or two or more thereof may be jointly used. In order to exhibit an effect of the addition of the resin, the content of the resin is preferably set to 1 part by mass or more, 3 parts by mass or more or 5 parts by mass or more with respect to 100 parts by mass of the thermoplastic elastomers. On the other hand, when the content of the resin becomes large, there is a concern that the sheet-shaped flexible electrode may become hard and the flexibility may be impaired. Therefore, when the flexibility is taken into account, the content of the resin is preferably set to 20 parts by mass or less or 10 parts by mass or less with respect to 100 parts by mass of the thermoplastic elastomers.

### [Shape, physical properties and the like]

The thickness of the sheet-shaped flexible electrode of the present invention is 50 µm or more and 500 µm or less. The sheet-shaped flexible electrode of the present invention may exhibit a uniform planar shape or may exhibit a mesh shape having openings. Fig. 2 shows a schematic plan view of a sheet-shaped flexible electrode having a mesh shape as one form of the sheet-shaped flexible electrode of the present invention. In Fig. 2, a portion other than openings is hatched for the convenience of description. As shown in Fig. 2, a sheet-shaped flexible electrode 1 exhibits a mesh shape having a number of circular openings 10. The sheet-shaped flexible electrode 1 is formed by extruding an elastomer composition containing carbon black dispersed in a predetermined styrene-based thermoplastic elastomer and then carrying out drilling. In a case where the sheet-shaped flexible electrode of the present invention has a mesh shape, the widths of lines that configure the mesh, the cross-sectional shapes and pitches of the lines, the shapes of the openings and the like are not limited. These may be appropriately determined in consideration of flexibility, conductive properties, sensing performance, shape-retaining properties and the like. For example, when the pitches are large, since the ratio of the openings (opening ratio) increases (meshes become coarse), in the case of configuring, for example, a capacitance sensor, which will be described below, it is easy to embed and integrate the sheet-shaped flexible electrode into an insulating layer. The planar shape of the opening may be a polygon other than a circle such as an oval, a rectangle or a rhombic.

From the viewpoint of having preferable conductive properties as electrodes, the volume resistivity of the sheet-shaped flexible electrode of the present invention is desirably 10 Ω·cm or less. The volume resistivity is more preferably 5 Ω·cm or less. In addition, from the viewpoint of flexibility, the type-A durometer hardness of the sheet-shaped flexible electrode of the present invention is desirably less than 92. The type-A durometer hardness is more preferably 90 or less.

The application of the sheet-shaped flexible electrode of the present invention is not particularly limited, and the sheet-shaped flexible electrode of the present invention is preferable as electrodes in piezoelectric sensors, capacitance sensors and the like. For example, in the former case, the sheet-shaped flexible electrodes of the present invention may be disposed with a piezoelectric layer containing an elastomer, piezoelectric particles or the like interposed therebetween. In the latter case, the sheet-shaped flexible electrodes of the present invention may be disposed with an insulating layer containing an elastomer or the like interposed therebetween. The capacitance sensors may be a sensor that detects electrostatic capacitance between two electrodes that are disposed with an insulating layer interposed therebetween or may be a sensor in which one is a detection electrode, the other is a shield electrode that shields noise to the detection electrode, and electrostatic capacitance generated between the detection electrode and a detection target is detected.

### <Method for producing sheet-shaped flexible electrode>

A method for producing the sheet-shaped flexible electrode of the present invention has an elastomer composition production step and a molding step.

### (1) Elastomer composition production step

The present step is a step of producing an elastomer composition including a thermoplastic elastomer and a conductive material containing carbon black, wherein the thermoplastic elastomer includes a styrene-based thermoplastic elastomer or includes a styrene-based thermoplastic elastomer and an olefin-based thermoplastic elastomer and satisfies the above-described two requirements (a) and (b) regarding the melt viscosity, and the amount of DBP absorbed by the carbon black is 300 cm³/100 g or more.

In the present step, a conductive material containing predetermined carbon black and, as necessary, a resin, a lubricant or the like are added to and kneaded with a predetermined thermoplastic elastomer, thereby producing an elastomer composition. For the kneading, a device that is ordinarily used such as a Banbury mixer, a kneader, a twin-screw kneader or a twin-screw extruder may be used. The temperature during the kneading is preferably set to, for example, approximately 180°C to 220°C in consideration of the softening point of the elastomer component or the like.

### (2) Molding step

In the present step, the elastomer composition produced in the prior step is molded into a sheet shape by injection or extrusion. As an injection molding machine or an extrusion molding machine, a device that is ordinarily used may be used. The temperature during the molding is preferably set to, for example, approximately 180°C to 220°C in consideration of the softening point of the elastomer component or the like.

After the present step, a rolling step, a pressing step or the like may be carried out. When a rolling step, a pressing step or the like is continuously carried out after the present step, the productivity further improves. In addition, when a sheet member obtained in the present step is rolled or pressed, it is possible to make the thickness thinner and uniform. In the case of molding the elastomer composition into a mesh shape, the elastomer composition may be molded into a mesh shape while being extruded in the present step by employing rotary extrusion molding or the like or the elastomer composition may be molded into a sheet shape in the present step and then drilled.

### [Examples]

Next, the present invention will be more specifically described with examples.

### <Production of conductive sheet>

First, predetermined raw materials were blended in amounts shown in Table 1 and Table 2 to be shown below and kneaded at a temperature of 200°C with a twin screw extruder for compounding ("TEX (registered trademark) 25αIII" produced by The Japan Steel Works, Ltd.), thereby producing a pellet-shaped elastomer composition. Next, T-die extrusion was carried out on the elastomer composition with a single screw extruder ("UT-25" manufactured by Research Laboratory of Plastics Technology Co., Ltd.) at a temperature of 200°C and a rotation speed of 100 rpm, thereby producing a conductive sheet that was 150 mm in width and 500 µm in thickness. Subsequently, the produced conductive sheet was hot-pressed to produce a thin film having a thickness of 150 µm. The hot pressing was carried out as described below. First, the produced conductive sheet was cut into a square shape that was 50 mm in length and 50 mm in width and sandwiched by release films ("CERAPEEL (registered trademark)" produced by Toray Industries, Inc.) from both sides in the thickness direction. The conductive sheet was installed in a press molding machine (150-ton pressing machine manufactured by Sanyu Industries Co., Ltd.) into which a 150 µm-thick SUS spacer had been put, the temperature was adjusted at 200°C for five minutes, and then the conductive sheet was hot-pressed at a load of 50 tons. After that, the conductive sheet was cooled, and the release films were peeled off. Regarding a conductive sheet of Comparative Example 1 to be described below, the thickness of a spacer that was installed in the press molding machine was set to 30 µm, thereby producing a thin film having a thickness of 30 µm. The conductive sheets of Examples 1 to 8 are included in the concept of the sheet-shaped flexible electrode in the present invention. The details of the raw materials used were as described below.

### [Thermoplastic elastomer]

### (1) Styrene-based thermoplastic elastomers

Styrene-based elastomer 1: "KRATON (registered trademark) MD1648" produced by KRATON Corporation, styrene content: 20 mass%.
Styrene-based elastomer 2: "KRATON (registered trademark) MD6951" produced by KRATON Corporation, styrene content: 34 mass%.
Styrene-based elastomer 3: "TUFTEC (registered trademark) H1221" produced by Asahi Kasei Corporation, styrene content: 30 mass%.
Styrene-based elastomer 4: "TUFTEC (registered trademark) H1043" produced by Asahi Kasei Corporation, styrene content: 67 mass%.
Styrene-based elastomer 5: "KRATON (registered trademark) G1726" produced by KRATON Corporation, styrene content: 30 mass%.
Styrene-based elastomer 6: "SEPTON (registered trademark) G4055" produced by Kuraray Co., Ltd., styrene content: 30 mass%.

### (2) Olefin-based thermoplastic elastomer

Ethylene-octene copolymer: "ENGAGE (registered trademark) 8137" produced by Dow.

### [Resin]

Homopolymer-polypropylene: "Sumitomo NOBLEN H501" produced by Sumitomo Chemical Co., Ltd., type-A durometer hardness: 95 or more.

### [Oil]

Paraffin oil: "DIANA (registered trademark) process oil PW-380" produced by Idemitsu Kosan Co., Ltd.

### [Conductive material]

### (1) Carbon black

Conductive carbon black 1: "KETJENBLACK^{®} EC600JD" produced by Lion Specialty Chemicals Co., Ltd., amount of DBP absorbed: 495 cm³/100 g.
Conductive carbon black 2: "KETJENBLACK^{®} EC300J" produced by Lion Specialty Chemicals Co., Ltd., amount of DBP absorbed: 360 cm³/100 g.
Conductive carbon black 3: "DENKA BLACK^{®} granule product" produced by Denka Company Limited, amount of DBP absorbed: 160 cm³/100 g.

### (2) Graphite

Flake graphite: "CMX40" produced by Nippon Kokuen Group.

### [Lubricant]

Stearamide: "ARMOSLIP (registered trademark) HT" produced by Lion Specialty Chemicals Co., Ltd.

### <Melt viscosity of thermoplastic elastomers>

The melt viscosity of the thermoplastic elastomers used was measured using "CAPILOGRAPH (registered trademark) 1DPMD-C" manufactured by Toyo Seiki Seisaku-sho, Ltd. (based on JIS K 7199: 1999). The melt viscosity in a low shear region was measured under conditions of a temperature of 200°C and a shear rate of 61 s⁻¹. The melt viscosity in a high shear region was measured under conditions of a temperature of 200°C and a shear rate of 1216 s⁻¹. In addition, the melt viscosity in the low shear region was divided by the melt viscosity in the high shear region, thereby calculating the ratio of the melt viscosity (ratio between melt viscosity = melt viscosity in low shear region / melt viscosity in high shear region).

### <Type-A durometer hardness of thermoplastic elastomers>

The type-A durometer hardness of the thermoplastic elastomers used was measured using a hardness meter based on JIS K 6253-3: 2012 ("ASKERP1-A type" manufactured by Kobunshi Keiki Co., Ltd.). The type-A durometer hardness was measured by overlaying three test pieces having a thickness of 1 mm, and a value after 15 seconds from the contact between the press needle and the test piece was employed.

### <Molding processability of elastomer compositions>

### [Capability of continuous extrusion]

Whether or not the produced elastomer compositions could be molded into a sheet shape by continuous extrusion was inspected. Elastomer compositions from which a favorable sheet could be continuously molded in the production of the above-described conductive sheets (thickness: 500 µm) were evaluated as continuously extrudable (indicated by O mark in the tables to be shown), and elastomer compositions from which a favorable sheet could not be molded were evaluated as continuously unextrudable (indicated by X mark in the same tables). "Elastomer compositions from which a favorable sheet could be continuously molded" refer to cases where a practical sheet that was 1 m or longer in the extrusion direction could be molded, and "elastomer compositions from which a favorable sheet could not be molded" refer to cases where sheets failed to come out from the front end ejection portion of the single screw extruder, sheets cracked from an end portion, holes were opened in sheets or a streak or pattern was formed on the sheet surfaces. For reference, Table 1 and Table 2 to be shown show the results in a case where the thickness of the sheet was set to 1000 µm.

### [Fusibility of sheets]

In a case where a sheet is wound and stored in a roll shape after extrusion molding and a case where heat used during molding remains in the sheet or the sheet is placed at high temperatures, different parts in contact with each other of the sheet are likely to stick to each other. This state was reproduced as described below, and the fusibility of the sheet was inspected.

First, the 500 µm-thick conductive sheet that was yet to be hot-pressed was cut out as much as 2 g and used as a test piece. The test piece was sandwiched by release films (same as above) and installed in the press molding machine (same as above), the temperature was adjusted at 200°C for five minutes, and then the test piece was hot-pressed at a load of 50 tons. The test piece was removed and left to stand for 15 seconds, then, the release films were peeled off, and the test piece was folded into halves. After that, the folded test piece was immediately placed on a flat plate at normal temperature, a 2.5 kg weight board was placed thereon, and the test piece was left to stand for five minutes. After that, the folded test piece was removed, and, in a case where different parts in contact with each other of the folded sheet did not stick to each other, the sheet was evaluated as being not fused (indicated by '⊙' in the tables to be shown), in a case where different parts in contact with each other of the folded sheet stuck to each other, but could be peeled off from each other, the sheet was evaluated as being slightly fused (indicated by 'O' in the same tables), and, in a case where different parts in contact with each other of the folded sheet stuck to each other and could not be peeled off from each other or the sheet ruptured while the parts in contact with each other were attempted to be peeled off from each other, the sheet was evaluated as being fused (indicated by 'X' in the same tables).

### <Properties of conductive sheets>

The properties of the produced conductive sheets were evaluated. Measurement items and measurement methods are as described below.

### [Volume resistivity]

The volume resistivity of the 150 µm-thick conductive sheets (the thickness was 30 µm in Comparative Example 1) were measured using a low resistivity meter "LORESTA (registered trademark) GP" (voltage: 5 V, based on JIS K 7194: 1994) manufactured by Nittoseiko Analytech Co., Ltd. In a case where the volume resistivity was 10 Ω·cm or less, the conductive properties were evaluated as favorable (indicated by O mark in the tables to be shown), and, in a case where the volume resistivity was more than 10 Ω·cm, the conductive properties were evaluated as poor (indicated by X mark in the same tables).

### [Electric resistance]

The 150 µm-thick conductive sheets (the thickness was 30 µm in Comparative Example 1) were cut into a rectangular shape that was 50 mm in length and 80 mm in width and used as test pieces, and the electric resistances on the surfaces of the test pieces were measured using a tester ("MODEL 3021" manufactured by Hioki E.E. Corporation). The electric resistance was measured by hitting the surface of the test piece with a pair of measuring needles perpendicularly. The measuring points hit by the measuring needles were points that were in the central portion (points 25 mm apart from both end portions, respectively) in the vertical direction and were 5 mm apart from both end portions in the transverse direction, respectively (the interval between the pair of measuring points was 70 mm). In addition, in a case where the electric resistance was less than 500 Ω, the conductive sheet was evaluated as excellent in terms of electrode performance (indicated by 'O' in the tables to be shown), in a case where the electric resistance was 500 Ω or more and less than 1000 Ω, the conductive sheet was evaluated as available as an electrode (indicated by 'Δ' in the same tables), and, in a case where the electric resistance was 1000 Ω or more, the conductive sheet was evaluated as unavailable as an electrode (indicated by 'X' in the same tables).

### [Resistance ratio]

In the case of being used as, for example, an electrode for sensors, there are cases where a load is applied to the conductive sheet in the thickness direction at lower temperatures than during extrusion molding when the conductive sheet is laminated on an insulating layer or the like, the surface shape is treated, or the like. At this time, there is a concern that the structure of carbon black may collapse or the conductive properties may deteriorate (the volume resistivity may increase). Therefore, a load was applied under two conditions of a low temperature and a high temperature, and the volume resistivity at those times were measured, thereby evaluating the processability of the conductive sheet.

First, the 500 µm-thick conductive sheets were cut into a square shape that was 50 mm in length and 50 mm in width and used as test pieces. These test pieces were installed in the press molding machine (same as above) and hot-pressed to a thickness of 150 µm at a load of 50 tons under two conditions of 100°C (low temperature) and 200°C (high temperature), respectively. Next, the volume resistivity of the test pieces was measured using the above-described low resistivity meter, and the volume resistivity of each test piece pressed at a low temperature was divided by the volume resistivity of each test piece pressed at a high temperature, thereby calculating the resistance ratio (resistance ratio = volume resistivity of test piece pressed at low temperature / volume resistivity of test piece pressed at high temperature). In this case, as the resistance ratio decreases, the change in the volume resistivity depending on temperatures, that is, the change in conductive properties decreases. In addition, in a case where the resistance ratio was less than 2.5, the processability was evaluated as extremely high (indicated by '⊙' in the tables to be shown), in a case where the resistance ratio was 2.5 or more and less than 5.0, the processability was evaluated as favorable (indicated by 'O' in the same tables), and, in a case where the resistance ratio was 5.0 or more, the processability was evaluated as poor (indicated by 'X' in the same tables).

### [Flexibility]

The flexibility of the conductive sheets was evaluated with the value of type-A durometer hardness. As a test piece, a laminate of three 1 mm-thick sheets produced from the same material as each conductive sheet was used, and the type-A durometer hardness of the test piece was measured using the above-described hardness meter. At this time, a value after 15 seconds from the contact between the press needle and the test piece was employed as the type-A durometer hardness. In addition, in a case where the type-A durometer hardness was less than 92, the conductive sheet was evaluated as flexible (indicated by O mark in the tables to be shown), and, in a case where the type-A durometer hardness was 92 or more, the conductive sheet was evaluated as not flexible (indicated by X mark in the same tables).

### [Presence or absence of bleeding]

First, the 150 µm-thick conductive sheets were cut into a rectangular shape that was 50 mm in length and 80 mm in width and used as test pieces. Next, a composition having 100 parts by mass of the above-described styrene-based elastomer 3 ("TUFTEC (registered trademark) H1221" produced by Asahi Kasei Corporation"), 50 parts by mass of an olefin-based thermoplastic elastomer ("ENGAGE (registered trademark) XLT8677" produced by Dow) and 200 parts by mass of magnesium oxide powder ("RF-50SC" produced by Ube Material Industries, Ltd.) was extruded, thereby producing an insulating sheet. The masses of the test piece and the insulating sheet were measured in advance. Subsequently, the insulating sheet was placed on a flat plate at normal temperature, the test piece was overlaid on the insulating sheet, furthermore, a 2.5 kg weight board was placed thereon, and the test piece was left to stand at normal temperature for one week. After that, the test piece and the insulating sheet were removed, and the masses thereof were measured. In addition, in a case where the masses of both the test piece and the insulating sheet did not change, bleeding was evaluated as not occurring (indicated by O mark in the tables to be shown), and, in a case where the mass of the test piece decreased, but the mass of the insulating sheet increased, bleeding was evaluated as occurring (indicated by X mark in the same tables).

The raw materials of the produced conductive sheets, the measurement results of the properties and the like are summarized in Table 1 and Table 2. In Table 2, the hardness of the ethylene-based elastomer 4 of Comparative Example 4 indicated by * mark is the type D durometer hardness.

**Table 1**

| | | | Example 1 | Example 2 | Example 3 | Example 4 | Example 5 | Example 6 | Example 7 | Example 8 |
|---|---|---|---|---|---|---|---|---|---|---|
| Raw materials (unit: parts by mass) | Styrene-based thermoplastic elastomers | Styrene-based elastomer 1 | 100 | - | 95 | 100 | 100 | 95 | - | - |
| | | Styrene-based elastomer 2 | - | 100 | - | - | - | - | - | - |
| | | Styrene-based elastomer 3 | - | - | - | - | - | - | 75 | 75 |
| | | Styrene-based elastomer 4 | - | - | - | - | - | - | - | - |
| | | Styrene-based elastomer 5 | - | - | - | - | - | - | - | - |
| | | Styrene-based elastomer 6 | - | - | - | - | - | - | - | - |
| | Olefin-based thermoplastic elastomer | Ethylene-octene copolymer | - | - | - | - | - | 5 | 25 | 25 |
| | Resin | Homopolymer-polypropylene | - | - | 5 | - | - | - | - | - |
| | Oil | Paraffin oil | - | - | - | - | - | - | - | - |
| | Conductive materials | Conductive carbon black 1 | 17 | 17 | 17 | - | 17 | 17 | 20 | 23 |
| | | Conductive carbon black 2 | - | - | - | 17 | - | - | - | - |
| | | Conductive carbon black 3 | - | - | - | - | - | - | - | - |
| | | Flake graphite | - | - | - | - | 5 | - | - | - |
| | Lubricant | Stearamide | 2 | 2 | 2 | 2 | 2 | 2 | 2 | 2 |
| Physical properties and the like of thermoplastic elastomers | | Melt viscosity in low shear region [Pa·s] | 193 | 668 | 193 | 193 | 193 | 180 | 656 | 656 |
| | | Ratio between melt viscosity | 2.4 | 3.2 | 2.4 | 2.4 | 2.4 | 2.4 | 2.4 | 2.4 |
| | | Type-A dur ometer hardness | 52 | 45 | 52 | 52 | 52 | 52 | 42 | 42 |
| | | Styrene content [mass%] | 20 | 34 | 20 | 20 | 20 | 20 | 12 | 12 |
| Amount of DBP absorbed by carbon black [cm³/100 g] | | | 495 | 495 | 495 | 360 | 495 | 495 | 495 | 495 |
| Molding processability of elastomer compositions | | Capability of 500 µm sheet continuous extrusion | ○ | ○ | ○ | ○ | ○ | ○ | ○ | ○ |
| | | Capability of 1000 µm sheet continuous extrusion | ○ | ○ | ○ | ○ | ○ | ○ | ○ | ○ |
| | | Fusibility of sheets | ○ | ○ | ⊙ | ○ | ○ | ○ | ○ | ○ |
| Physical properties of conductive sheets | | Volume resistivity [Ω·cm] | ○ 2.0 | ○ 2.1 | ○ 1.9 | ○ 4.8 | ○ 1.0 | ○ 2.0 | ○ 0.8 | ○ 0.5 |
| | | Electric resistance [Ω] | ○ 300 | ○ 310 | ○ 280 | Δ 950 | ○ 100 | ○ 300 | ○ 80 | ○ 50 |
| | | Resistance ratio | ○ 3.0 | ○ 3.6 | ⊙ 2.2 | - | ○ 3.4 | ○ 3.0 | ⊙ 0.9 | ⊙ 0.6 |
| | | Type-A durometer hardness (flexibility) | ○ 83 | ○ 89 | ○ 88 | ○ 82 | ○ 88 | ○ 81 | ○ 90 | ○ 91 |
| | | Presence or absence of bleeding | ○ | ○ | ○ | ○ | ○ | ○ | ○ | ○ |

**Table 2**

| | | | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 | Comparative Example 10 |
|---|---|---|---|---|---|---|---|---|---|---|---|---|
| Raw materials (unit: parts by mass) | Styrene-based thermoplastic elastomers | Styrene-based elastomer 1 | 100 | - | - | - | - | - | - | - | - | - |
| | | Styrene-based elastomer 2 | - | - | - | - | - | - | - | | - | - |
| | | Styrene-based elastomer 3 | - | 100 | 80 | - | - | - | - | - | - | - |
| | | Styrene-based elastomer 4 | - | - | - | 100 | - | - | - | - | - | - |
| | | Styrene-based elastomer 5 | - | - | - | - | 100 | - | - | - | - | - |
| | | Styrene-based elastomer 6 | - | - | - | - | - | 100 | 50 | - | - | - |
| | Olefin-based thermoplastic elastomer | Ethylene-octene copolymer | - | - | - | - | - | - | - | 100 | - | - |
| | Resin | Homopolymer-polypropylene | - | - | - | - | - | - | - | - | - | - |
| | Oil | Paraffin oil | - | - | 20 | - | - | | 50 | - | - | - |
| | Conductive materials | Conductive carbon black 1 | 17 | 17 | 17 | 17 | 17 | 17 | 17 | 17 | - | - |
| | | Conductive carbon black 2 | - | - | - | - | - | - | - | - | - | - |
| | | Conductive carbon black 3 | - | - | - | - | - | - | - | - | 17 | 50 |
| | | Flake graphite | - | - | - | - | - | - | - | - | - | - |
| | Lubricant | Stearamide | 2 | 2 | 2 | 2 | 2 | 2 | 2 | 2 | 2 | 2 |
| Physical properties and the like of thermoplastic elastomers | | Melt viscosity in low shear region [Pa·s] | 193 | 2026 | 2026 | 1202 | 380 | Unmeasurable | Unmeasurable | 525 | 193 | 193 |
| | | Ratio between melt viscosity | 2.4 | 7.1 | 7.1 | 5.2 | 4.1 | | | 3.3 | 2.4 | 2.4 |
| | | Type-A durometer hardness | 52 | 42 | 42 | 72* | 70 | | | 60 | 52 | 52 |
| | | Styrene content [mass%] | 20 | 12 | 12 | 67 | 30 | 30 | 30 | - | 20 | 20 |
| Amount of DBP absorbed by carbon black [cm'/100 g] | | | 495 | 495 | 495 | 495 | 495 | 495 | 495 | 495 | 160 | 160 |
| Molding processability of elastomer compositions | | Capability of 500 µm sheet continuous extrusion | ○ | X | X | X | X | X | X | ○ | ○ | X |
| | | Capability of 1000 µm sheet continuous extrusion | ○ | ○ | ○ | X | ○ | X | X | ○ | ○ | ○ |
| | | Fusibility of sheets | - | ○ | ○ | - | ○ | - | - | X | ○ | ○ |
| Physical properties of conductive sheets | | Volume resistivity [Ω·cm] | ○ 2.0 | ○ 2.0 | ○ 2.1 | - | ○ 2.0 | - | - | ○ 3.5 | X > 1 × 10³ | X 5 × 10¹ |
| | | Electric resistance [Ω] | C 1400 | ○ 295 | ○ 310 | - | ○ 300 | - | - | Δ 800 | X > 1 × 10⁵ | X 5 × 10³ |
| | | Resistance ratio | - | X 6.8 | - | - | - | - | - | ○ 78 | - | - |
| | | Type-A durometer hardness (flexibility) | ○ 83 | ○ 81 | ○ 73 | - | X 93 | - | - | ○ 78 | - | - |
| | | Presence or absence of bleeding | ○ | ○ | X | - | ○ | - | - | ○ | - | - |

As shown in Table 1, the conductive sheets of Examples 1 to 8 had a thermoplastic elastomer that satisfied the above-described two requirements (a) and (b) regarding the melt viscosity and carbon black by which the amount of DBP absorbed was 300 cm³/100 g or more. Therefore, it was possible to continuously mold the conductive sheets in a sheet shape by extrusion molding, and the problem of the fusion of the obtained sheets was also not on a problematic level. Particularly, in the conductive sheet of Example 3 with which the resin was blended, different parts in contact with each other did not stick to each other, and it was confirmed that the conductive sheet was less likely to be fused. In addition, it was confirmed that all of the conductive sheets of Examples 1 to 8 had a thin thickness of 150 µm and were excellent in terms of conductive properties and flexibility. Particularly, in the conductive sheet of Example 5 containing not only carbon black but also graphite as the conductive material, the conductive properties became favorable. In addition, in the conductive sheet of Example 3 with which the resin was blended, the resistance ratio became small, and it was confirmed that the change in the conductive properties was small in a case where the conductive sheet was processed at low temperatures during molding. In addition, in the conductive sheets of Examples 7 and 8 in which the styrene-based thermoplastic elastomer and the olefin-based thermoplastic elastomer were jointly used and the amount of the olefin-based thermoplastic elastomer blended was relatively large, the structure was less likely to change even when the amount of the carbon black blended was increased. Therefore, it was possible to realize high conductive properties, the resistance ratio became significantly small, and the processability improved. Furthermore, since the conductive sheets of Examples 1 to 8 contained no oils, bleeding did not occur even when the conductive sheet was laminated with a different member (insulating sheet).

In contrast, as shown in Table 2, according to the conductive sheets of Comparative Examples 1, 9 and 10, it was confirmed that containing the thermoplastic elastomer that satisfies the above-described two requirements (a) and (b) regarding the melt viscosity is not enough to obtain desired conductive properties and molding processability. That is, in the conductive sheet of Comparative Example 1, since the thickness was too thin (30 µm), the electric resistance on the surface became large, and it was not possible to realize conductive properties favorable enough for die conductive sheet to be used as electrodes. In the conductive sheets of Comparative Examples 9 and 10, since the amount of DBP absorbed by the carbon black used was small (was not 300 cm³/100 g or more), the conductive properties became low. In the conductive sheet of Comparative Example 10, since the amount of the carbon black blended was large, the molding processability also deteriorated.

In the conductive sheets of Comparative Examples 2 to 4, 6 and 7, the thermoplastic elastomers used did not satisfy the above-described two requirements (a) and (b) regarding the melt viscosity. Among them, the styrene-based elastomer 6 used in the conductive sheets of Comparative Examples 6 and 7 did not flow under predetermined conditions, which made it impossible to measure the melt viscosity. Therefore, it was not possible to continuously mold these conductive sheets into a 500 µm-thick sheet shape by extrusion molding, and consequently, the molding processability deteriorated. In the conductive sheet of Comparative Example 8, only the olefin-based thermoplastic elastomer was used. Therefore, different parts in contact with each other of the obtained sheet were fused to each other in the end. In the conductive sheet of Comparative Example 5, the thermoplastic elastomer used satisfied, between the above-described two requirements regarding the melt viscosity, (a) but failed to satisfy (b). Therefore, it was not possible to continuously mold the conductive sheet into a 500 [µm-thick sheet shape by extrusion molding, and consequently, the molding processability deteriorated. In addition, in the conductive sheet of Comparative Example 5, the flexibility also deteriorated.

### Reference Characters List

| | |
|---|---|
| 1: Sheet-shaped flexible electrode | 10: Opening |

## Claims

1. A sheet-shaped flexible electrode, comprising:
a thermoplastic elastomer, including a styrene-based thermoplastic elastomer, or including a styrene-based thermoplastic elastomer and an olefin-based thermoplastic elastomer; and
a conductive material containing carbon black,
wherein a melt viscosity of the thermoplastic elastomer at 200°C in a low shear region with a shear rate of 60 s⁻¹ or more and 200 s⁻¹ or less is 100 Pa·s or more and 800 Pa·s or less, and is four times or less a melt viscosity of the thermoplastic elastomer at 200°C in a high shear region with a shear rate of 1000 s⁻¹ or more and 1220 s⁻¹ or less,
an amount of dibutyl phthalate (DBP) absorbed by the carbon black is 300 cm³/100 g or more, and
a thickness of the sheet-shaped flexible electrode is 50 µm or more and 500 µm or less.

2. The sheet-shaped flexible electrode according to claim 1, wherein the styrene-based thermoplastic elastomer has a styrene content of 35 mass% or less.

3. The sheet-shaped flexible electrode according to claim 1 or 2, wherein the thermoplastic elastomer has a type-A durometer hardness of less than 60.

4. The sheet-shaped flexible electrode according to any one of claims 1 to 3, wherein the conductive material further contains graphite.

5. The sheet-shaped flexible electrode according to any one of claims 1 to 4, wherein a content of the conductive material is 10 parts by mass or more and 100 parts by mass or less with respect to 100 parts by mass of the thermoplastic elastomer.

6. The sheet-shaped flexible electrode according to any one of claims 1 to 5, further comprising a resin having a type-A durometer hardness of 80 or more.

7. The sheet-shaped flexible electrode according to claim 6, wherein a content of the resin is 1 part by mass or more and 20 parts by mass or less with respect to 100 parts by mass of the thermoplastic elastomer.

8. The sheet-shaped flexible electrode according to claim 6 or 7, wherein the resin is one or more selected from the group consisting of polyethylene, polypropylene, polyamide, polyethylene terephthalate and polycarbonate.

9. The sheet-shaped flexible electrode according to any one of claims 1 to 8, wherein a volume resistivity of the sheet-shaped flexible electrode is 10 Ω·cm or less.

10. The sheet-shaped flexible electrode according to any one of claims 1 to 9, which is used as an electrode of a capacitance sensor.

11. The sheet-shaped flexible electrode according to any one of claims 1 to 10, which has a mesh shape.

12. The sheet-shaped flexible electrode according to any one of claims 1 to 11, further comprising one or more selected from the group consisting of a fatty acid and a fatty acid compound.

13. The sheet-shaped flexible electrode according to any one of claims 1 to 12, wherein a resistance ratio of the sheet-shaped flexible electrode that is calculated with equation (i) below in a case of being pressed under the same conditions except temperature is less than 5, resistance ratio = (volume resistivity in the case of being pressed at 100°C)/(volume resistivity in the case of being pressed at 200°C)

14. A method for producing the sheet-shaped flexible electrode according to any one of claims 1 to 13, comprising:
an elastomer composition production step of producing an elastomer composition, wherein the elastomer composition includes
a thermoplastic elastomer, including a styrene-based thermoplastic elastomer, or including a styrene-based thermoplastic elastomer and an olefin-based thermoplastic elastomer, wherein a melt viscosity of the thermoplastic elastomer at 200°C in a low shear region with a shear rate of 60 s⁻¹ or more and 200 s⁻¹ or less is 100 Pa·s or more and 800 Pa-s or less, and is four times or less a melt viscosity of the thermoplastic elastomer at 200°C in a high shear region with a shear rate of 1000 s⁻¹ or more and 1220 s⁻¹ or less, and
a conductive material containing carbon black, wherein an amount of dibutyl phthalate (DBP) absorbed by the carbon black is 300 cm³/100 g or more; and
a molding step of molding the elastomer composition into a sheet shape by injecting or extruding.

## Patentansprüche

1. Folienförmige, flexible Elektrode, umfassend:
ein thermoplastisches Elastomer, beinhaltend ein auf Styrol basierendes thermoplastisches Elastomer, oder beinhaltend ein auf Styrol basierendes thermoplastisches Elastomer und ein auf Olefin basierendes thermoplastisches Elastomer; und
ein leitfähiges Material, enthaltend Ruß,
wobei eine Schmelzviskosität des thermoplastischen Elastomers bei 200°C in einem Bereich niedriger Scherung mit einer Scherrate von 60 s⁻¹ oder mehr und 200 s⁻¹ oder weniger 100 Pa.s oder mehr und 800 Pa.s oder weniger beträgt und das Vierfache oder weniger einer Schmelzviskosität des thermoplastischen Elastomers bei 200°C in einem Bereich hoher Scherung mit einer Scherrate von 1000 s⁻¹ oder mehr und 1220 s⁻¹ oder weniger beträgt,
eine Menge an Dibutylphthalat (DBP), das von dem Ruß absorbiert ist, 300 cm³/100 g oder mehr beträgt, und
eine Dicke der folienförmigen, flexiblen Elektrode 50 µm oder mehr und 500 µm oder weniger beträgt.

2. Folienförmige, flexible Elektrode nach Anspruch 1, wobei das auf Styrol basierende, thermoplastische Elastomer einen Styrolgehalt von 35 Massen-% oder weniger aufweist.

3. Folienförmige, flexible Elektrode nach Anspruch 1 oder 2, wobei das thermoplastische Elastomer eine Typ-A-Durometer-Härte von weniger als 60 aufweist.

4. Folienförmige, flexible Elektrode nach einem der Ansprüche 1 bis 3, wobei das leitfähige Material weiter Graphit enthält.

5. Folienförmige, flexible Elektrode nach einem der Ansprüche 1 bis 4, wobei ein Gehalt des leitfähigen Materials 10 Massenteile oder mehr und 100 Massenteile oder weniger, bezogen auf 100 Massenteile des thermoplastischen Elastomers, beträgt.

6. Folienförmige, flexible Elektrode nach einem der Ansprüche 1 bis 5, weiter umfassend ein Harz mit einer Typ-A-Durometer-Härte von 80 oder mehr.

7. Folienförmige, flexible Elektrode nach Anspruch 6, wobei ein Gehalt des Harzes 1 Massenteil oder mehr und 20 Massenteile oder weniger, bezogen auf 100 Massenteile des thermoplastischen Elastomers, beträgt.

8. Folienförmige, flexible Elektrode nach Anspruch 6 oder 7, wobei das Harz eines oder mehrere, ausgewählt aus der Gruppe, bestehend aus Polyethylen, Polypropylen, Polyamid, Polyethylenterephthalat und Polycarbonat, ist.

9. Folienförmige, flexible Elektrode nach einem der Ansprüche 1 bis 8, wobei ein Volumenwiderstand der folienförmigen, flexiblen Elektrode 10 Ω·cm oder weniger beträgt.

10. Folienförmige, flexible Elektrode nach einem der Ansprüche 1 bis 9, die als eine Elektrode eines kapazitiven Sensors verwendet wird.

11. Folienförmige, flexible Elektrode nach einem der Ansprüche 1 bis 10, die eine Maschenform aufweist.

12. Folienförmige, flexible Elektrode nach einem der Ansprüche 1 bis 11, die weiter eine oder mehrere, ausgewählt aus der Gruppe, bestehend aus einer Fettsäure und einer Fettsäureverbindungen, umfasst.

13. Folienförmige, flexible Elektrode nach einem der Ansprüche 1 bis 12, wobei ein Widerstandsverhältnis der folienförmigen, flexiblen Elektrode, das mit der nachstehenden Gleichung (i) im Falle des Pressens unter denselben Bedingungen außer der Temperatur berechnet wird, weniger als 5 beträgt, Widerstandsverhältnis = (Volumenwiderstand im Fall des Pressens bei 100°C)/(Volumenwiderstand im Fall des Pressens bei 200°C)

14. Verfahren zur Herstellung der folienförmigen, flexiblen Elektrode nach einem der Ansprüche 1 bis 13, umfassend:
einen Elastomerzusammensetzung-Herstellungsschritt des Herstellens einer Elastomerzusammensetzung,
wobei die Elastomerzusammensetzung
ein thermoplastisches Elastomer, beinhaltend ein auf Styrol basierendes thermoplastisches Elastomer, oder beinhaltend ein auf Styrol basierendes thermoplastisches Elastomer und ein auf Olefin basierendes thermoplastisches Elastomer, wobei eine Schmelzviskosität des thermoplastischen Elastomers bei 200°C in einem Bereich niedriger Scherung mit einer Scherrate von 60 s⁻¹ oder mehr und 200 s⁻¹ oder weniger 100 Pa.s oder mehr und 800 Pa.s oder weniger beträgt und das Vierfache oder weniger einer Schmelzviskosität des thermoplastischen Elastomers bei 200°C in einem Bereich hoher Scherung mit einer Scherrate von 1000 s⁻¹ oder mehr und 1220 s⁻¹ oder weniger beträgt, und ein leitfähiges Material, enthaltend Ruß, beinhaltet,
wobei eine Menge an Dibutylphthalat (DBP), das von dem Ruß absorbiert ist, 300 cm³/100 g oder mehr beträgt; und
einen Formungsschritt des Formens der Elastomerzusammensetzung in eine Folienform durch Einspritzen oder Extrudieren.

## Revendications

1. Électrode flexible en forme de feuille, comprenant :
un élastomère thermoplastique, incluant un élastomère thermoplastique à base de styrène, ou incluant un élastomère thermoplastique à base de styrène et un élastomère thermoplastique à base d'oléfine ; et
un matériau conducteur contenant du noir de carbone,
dans laquelle une viscosité à l'état fondu de l'élastomère thermoplastique à 200 °C dans une région à faible cisaillement avec un taux de cisaillement de 60 s⁻¹ ou plus et 200 s⁻¹ ou moins est de 100 Pa·s ou plus et 800 Pa·s ou moins, et est quatre fois ou moins une viscosité à l'état fondu de l'élastomère thermoplastique à 200 °C dans une région à cisaillement élevé avec un taux de cisaillement de 1000 s⁻¹ ou plus et 1220 s⁻¹ ou moins,
une quantité de dibutylphtalate (DBP) absorbée par le noir de carbone est de 300 cm³/100 g ou plus, et
une épaisseur de l'électrode flexible en forme de feuille est de 50 µm ou plus et 500 µm ou moins.

2. Électrode flexible en forme de feuille selon la revendication 1, dans laquelle l'élastomère thermoplastique à base de styrène a une teneur en styrène de 35 % en masse ou moins.

3. Électrode flexible en forme de feuille selon la revendication 1 ou 2, dans laquelle l'élastomère thermoplastique a une dureté d'après duromètre de type A de moins de 60.

4. Électrode flexible en forme de feuille selon l'une quelconque des revendications 1 à 3, dans laquelle le matériau conducteur contient en outre du graphite.

5. Électrode flexible en forme de feuille selon l'une quelconque des revendications 1 à 4, dans laquelle une teneur en le matériau conducteur est de 10 parties en masse ou plus et 100 parties en masse ou moins par rapport à 100 parties en masse de l'élastomère thermoplastique.

6. Électrode flexible en forme de feuille selon l'une quelconque des revendications 1 à 5, comprenant en outre une résine ayant une dureté d'après duromètre de type A de 80 ou plus.

7. Électrode flexible en forme de feuille selon la revendication 6, dans laquelle une teneur en la résine est de 1 partie en masse ou plus et 20 parties en masse ou moins par rapport à 100 parties en masse de l'élastomère thermoplastique.

8. Électrode flexible en forme de feuille selon la revendication 6 ou 7, dans laquelle la résine est une ou plusieurs sélectionnées parmi le groupe constitué du polyéthylène, polypropylène, polyamide, polyéthylène téréphtalate et polycarbonate.

9. Électrode flexible en forme de feuille selon l'une quelconque des revendications 1 à 8, dans laquelle une résistivité volumique de l'électrode flexible en forme de feuille est de 10 Ω·cm ou moins.

10. Électrode flexible en forme de feuille selon l'une quelconque des revendications 1 à 9, qui est utilisée en tant qu'électrode d'un capteur de capacitance.

11. Électrode flexible en forme de feuille selon l'une quelconque des revendications 1 à 10, qui a une forme de maille.

12. Électrode flexible en forme de feuille selon l'une quelconque des revendications 1 à 11, comprenant en outre un ou plusieurs composés sélectionnés parmi le groupe constitué d'un acide gras et d'un composé d'acide gras.

13. Électrode flexible en forme de feuille selon l'une quelconque des revendications 1 à 12, dans laquelle un rapport de de l'électrode flexible en forme de feuille qui est calculé avec l'équation (i) ci-dessous dans le cas d'un pressage dans les mêmes conditions mis à part que la température est inférieure à 5, rapport de résistance = (résistivité volumique dans le cas d'un pressage à 100°C)/(résistivité volumique dans le cas d'un pressage à 200°C)

14. Procédé de production de l'électrode flexible en forme de feuille selon l'une quelconque des revendications 1 à 13, comprenant :
une étape de production de composition d'élastomère consistant à produire une composition d'élastomère,
dans lequel la composition d'élastomère inclut
un élastomère thermoplastique, incluant un élastomère thermoplastique à base de styrène, ou incluant un élastomère thermoplastique à base de styrène et un élastomère thermoplastique à base d'oléfine, dans lequel une viscosité à l'état fondu de l'élastomère thermoplastique à 200 °C dans une région à faible cisaillement avec un taux de cisaillement de 60 s⁻¹ ou plus et 200 s⁻¹ ou moins est de 100 Pa·s ou plus et 800 Pa·s ou moins, et est quatre fois ou moins une viscosité à l'état fondu de l'élastomère thermoplastique à 200 °C dans une région à cisaillement élevée avec un taux de cisaillement de 1000 s⁻¹ ou plus et 1220 s⁻¹ ou moins, et
un matériau conducteur contenant du noir de carbone, dans lequel une quantité de dibutylphtalate (DBP) absorbée par le noir de carbone est de 300 cm³/100 g ou plus ; et
une étape de moulage consistant à mouler la composition d'élastomère en une forme de feuille par injection ou extrusion.
